# EUROPEAN PATENT SPECIFICATION

(11) **EP 0 280 800 B1**
(45) Date of publication and mention of the grant of the patent: **18.05.1994**
(21) Application number: 87301830.3
(22) Date of filing: 03.03.1987
(51) Int. Cl.: G01S 13/02, H03K 17/58

(54) **Narrow range gate baseband receiver**
Basisbandempfänger mit Entfernungsauftastschaltung für kurze Dauer
Récepteur à bande de base avec porte de distance étroite

(43) Date of publication of application: 07.09.1988
(73) Proprietor: Unisys Corporation, Blue Bell Pennsylvania 19424 (US)
(72) Inventor: Ross, Gerald Fred, Lexington Massachusetts 02173 (US); Robbins, Kenneth Warren, Wilmington Massachusetts 01887 (US)
(74) Representative: Singleton, Jeffrey

(56) References cited:
- US-A- 3 209 170
- US-A- 3 222 549
- US-A- 3 794 996
- US-A- 3 813 558
- US-A- 3 858 204
- US-A- 3 983 422

## Description

The present invention relates to baseband receivers and more particularly to baseband receivers having high sensitivities within a narrow range gate.

A need exists for a sensitive baseband receiver operable within a range gate of several nanoseconds that provides range resolutions in the order of feet. Such a receiver may act as a spatial filter to substantially reduce chaff interference, may be utilised for target profile discrimination, and may act as a clutter filter by adjusting a range gate to provide a range window which excludes the clutter source. A receiver of this type should be held in the "OFF" state except for a short interval, measured in nanoseconds, during which it is switched to the "ON" state. The sensitivity of the receiver in the "ON" state should be of the order of millivolts, while in the "OFF" state it should not respond to signals of the order of half a volt.

To achieve the desired characteristics, it is necessary to attenuate the gain transients by more than 50 dB in a fraction of a nanosecond to prevent false triggering (i.e. receiver triggering on the rise or fall of the range gate pulse itself). Additionally, significant pulse stretching must be performed since the signal can enter the range gate at the beginning or end of the time window, resulting in output pulses that range from a small fraction of a range gate width to a full range gate width. These pulses contain insufficient energy to trigger the logic circuit in the following CFAR registers and must be stretched. Baseband receivers of the prior art, such as the types disclosed in US-A-3,662,316 and US-A-3,750,025 do not provide the desired sensitivity and in some instances do not possess range gated operation.

The present invention is defined in the appended claims and provides a range gated baseband receiver which utilises two highly sensitive tunnel diodes, initially biased in the insensitive high states, coupled with opposing polarities in a bridge circuit. One diode is additionally coupled to an antenna, while the second has no external coupling. The anode of one, and the cathode of the other, tunnel diode are respectively coupled to a node where the sum of their output signals is realised. A third tunnel diode, which has a higher triggering threshold than the oppositely poled tunnel diodes, is coupled to the sum node and a resetting circuit. This diode and resetting circuit combination provides an output signal level and pulse duration which may be processed by CFAR receivers, as for example, the CFAR receiver disclosed in US-A-3,983,422.

Range gates, of substantially equal duration and opposite polarity, from a range gate generator, are coupled via differentiating circuits to the oppositely poled tunnel diodes. The leading pulse of the doublets formed by the differentiating circuits reset the oppositely poled tunnel diodes to their sensitive low states, while the second pulse of the doublet resets these tunnel diodes to their insensitive high states. Since the sum of the tunnel diode signals is coupled to the sum node, the signal thereat is substantially zero at all times in the absence of a signal received from the antenna. When a signal is coupled from the antenna, the bridge balance is disturbed causing the null at the sum node to be replaced by a signal level representative of the received signal. This circuit unbalance can only occur during the period in which the oppositely poled tunnel diodes are in their low state, i.e. during the range gate interval, because the received signal is incapable of causing the tunnel diode to which it is coupled to change from an initial high level state. Thus, only during the range gate interval can a signal appear at the sum node. This signal causes the third tunnel diode to change from a low level to a high level state. After the transition, the third tunnel diode is reset to the low level state by the resetting circuit coupled thereto. The resulting pulse output is then coupled to CFAR registers for processing.

The oppositely poled tunnel diodes are so sensitive that a signal resulting from the generation of the positive range gate can trigger the positively poled tunnel diode. To avoid such false alarms, delays are appropriately introduced to activate and deactivate the positively poled tunnel diode by the negative range gate before the positive range gate is coupled to the bridge circuit. The delays between the range gate generator and the oppositely poled tunnel diodes and the delay between these diodes and the sum node are adjusted such that the total delay from the range gate generator to the sum node is equal for each path, thus maintaining a null at the sum node at all times in the absence of a signal coupled to the bridge circuit from the receiving antenna.

In a second embodiment of the invention, the second tunnel diode, the one not coupled to the receiving antenna, is removed. A window of sensitivity for the first tunnel diode in the bridge circuit, the one coupled to the antenna, is established as previously described. A pulse of substantially equal amplitude but of opposite polarity to the voltage coupled to the bridge from the first tunnel diode in its low level state is coupled to the bridge during the sensitivity interval to establish a null at the sum node. Transitions of the first tunnel diode during the window interval, caused by signals coupled from the receiving antenna upset the bridge balance and establish a signal at the sum node that is detected by the third tunnel diode.

Apparatus for detecting pulsed signals in accordance with the present invention will now be described in greater detail, by way of example, with reference to the accompanying drawings, in which,
Figure 1 is a schematic diagram of a first preferred embodiment of the invention,
Figure 2 includes a plurality of waveforms useful for explaining the invention and
Figure 3 is a schematic diagram of a second preferred embodiment of the invention.

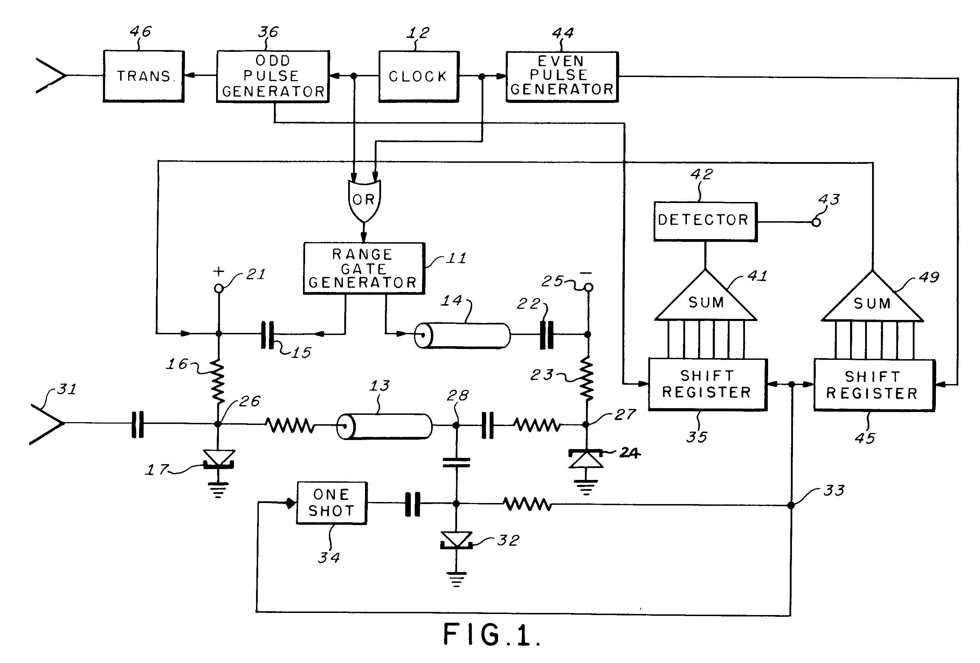

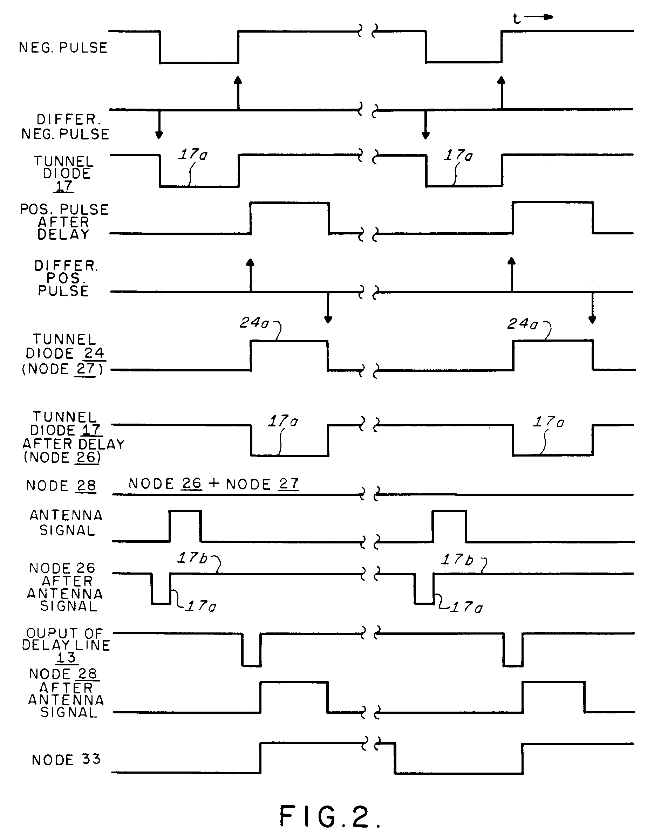

Referring to Figure 1, there is shown a schematic diagram of a baseband range gated receiver wherein a range gate generator 11, activated by pulses from a clock 12, couples a negative-going pulse to a capacitor 15 and a positive-going pulse to delay line 14. The negative-going and positive-going waveforms are shown in Figure 2. The negative-going pulse at the capacitor 15 is differentiated in a differentiating circuit including the capacitor 15 and a resistor 16, causing a negative impulse in response to the leading edge of the negative-going pulse and a positive impulse in response to the trailing edge of the negative-going pulse, as shown in Figure 2, to be coupled to a tunnel diode 17, which may be a GE 262A. A bias voltage is applied to the tunnel diode 17 via a terminal 21 and the resistor 16 to maintain the tunnel diode 17 in its insensitive high state until a range gate signal is received. With the application of the negative impulse, resulting from the differentiation of the negative-going pulse, to the tunnel diode 17, the tunnel diode 17 is set to its sensitive low state 17a in Figure 2.

Similarly, the delayed positive pulse from the delay line 14 is differentiated in a differentiating circuit including a capacitor 22 and a resistor 23. The positive impulse generated in response to the leading edge of the positive pulse and the negative impulse generated in response to the trailing edge thereof, shown in Figure 2, are coupled to a tunnel diode 24 positioned in the circuit with a polarity opposite to that of the tunnel diode 17. A negative voltage bias is coupled from a terminal 25 and the resistor 23 to the tunnel diode 24 to maintain the latter in its insensitive high state until the positive impulse is received. When the positive impulse is coupled to the tunnel diode 24, it is set to its sensitive low state 24a in Figure 2. After the coupling of the negative and positive impulses to the tunnel diodes 17 and 24, respectively, substantially equal and opposite voltages exists at nodes 26 and 27. After the delay of the signal at node 26 by a delay line 13, these voltages add, as shown in Figure 2, to establish a voltage that is substantially zero at node 28. In the absence of a signal applied to the bridge at node 26 from an antenna 31, the tunnel diodes 17 and 24 remain in the sensitive low states and a substantially zero voltage persists at node 28 for the duration of the range gate. At the expiration of the range gate, the positive impulse generated in response to the trailing edge of the negative pulse and the negative impulse generated in response to the trailing edge of the positive pulse reset the tunnel diodes 17 and 24, respectively, to the insensitive high states and a null continues to exist at node 28.

A voltage at node 26 due to the reception of a signal by the antenna 31 during the range gate interval causes the tunnel diode 17 to switch from the low state to its high state, thereby establishing a higher voltage level at node 26, causing the voltage at node 28 to increase from the substantially zero level as shown in Figure 2. Once the received signal from the antenna 31 returns the tunnel diode 17 to its high state 17b, it cannot change states again until the impulse generated in response to the leading edge of the next negative-going pulse produced by the range gate generator. The tunnel diode 24, not coupled to the antenna 31, remains in its low state until the negative impulse generated in response to the trailing edge of the positive-going pulse produced by the range gate generator 11 causes it to reset to its high state, thereby re-establishing the substantially zero voltage level at node 28. Thus, a positive voltage exists at node 28 over the time interval from the reception of the signal by the antenna 31 and the conclusion of the range gate interval. This positive signal causes a tunnel diode 32, which may be of the GaAs type, maintained in its low level state by a bias circuit not shown, to set to its high level state, thereby providing a positive voltage at node 33. This voltage causes a one shot device 34 to fire and couple a negative-going pulse to the tunnel diode 32 causing it to reset to its low level state, thereby establishing a pulse at node 33, as shown in Figure 2, that is entered into a shift register 35 which is clocked substantially in synchronism with range gate 11 by an odd pulse generator 36.

Design of the high sensitivity tunnel diode circuitry requires considerable care to prevent firing of the detector tunnel diode 17 during the range gate interval when the signal is not received by the antenna 31. The sensitivity of the tunnel diode 17 is such that a signal leaked from the range gate generator 11 can cause tunnel diode 17 to alter states and unbalance the bridge. To prevent this misfiring, the delay line 14 is introduced. With this delay, the tunnel diode 17 is set to its low level state and reset to its high level state by the negative-going pulse from the range gate generator 11 before the positive-going pulse is provided. The delay line 13 is coupled between nodes 26, 28 to obtain substantially equal delays between the range gate generator 11 and node 28 for the positive and negative-going pulse signals so that substantial signal cancellation is realised at node 28.

Pulses from node 33 are coupled to the serial input terminal of the shift register 35 and entered into the stage thereof made available by the signals from the odd pulse generator 36. With each transmitted odd pulse, the register 35 is shifted and signals representative of the state of the tunnel diode 32 are entered into the available stage. Each register of the shift register 35 is coupled via parallel output terminals, to a sum circuit 41 wherefrom a signal corresponding to the number of low-to-high level stage transitions of the tunnel diode 32 is coupled to a detector 42 which provides an output signal at a teminal 43 when the signal level coupled thereto from the sum circuit 41 exceeds a predetermined threshold.

With each even pulse, of the clock 12, the even pulse generator 44 enables the next available stage of a shift register 45 for a duration of the range interval. Since a transmitter 46 is triggered only by the occurrence of the odd pulses from the odd pulse generator 36, the signals coupled to node 26 during the range gate generated in response to the even pulses that cause low-to-high state transitions of the tunnel diode 17 are due to interfering sources or noise. As previously described, positive impulses generated by the differentiation of the negative pulse from the range gate generator 11 set the tunnel diode 17 to its low level state. Pulses caused by transitions to the high level state cause the bridge to become unbalanced, establishing a voltage at node 28 that triggers the tunnel diode 32 thus coupling a pulse, as previously described, to the available stage in the shift register 45. With each successive even pulse, another stage is enabled and signals representative of the state of the tunnel diode 32 during the range gate interval are entered into the available stage. These signals are coupled to a sum network 49 via the parallel output terminals of the shift register 45. The signal representative of the number of low-to-high level state transitions of the tunnel diode 32 over a number of range gate intervals is coupled via the resistor 16 to the tunnel diode 17 to provide a continuously adjusted bias voltage thereto that is a function of the number of low-to-high transition of the tunnel diode 32 caused by noise or interfering signals.

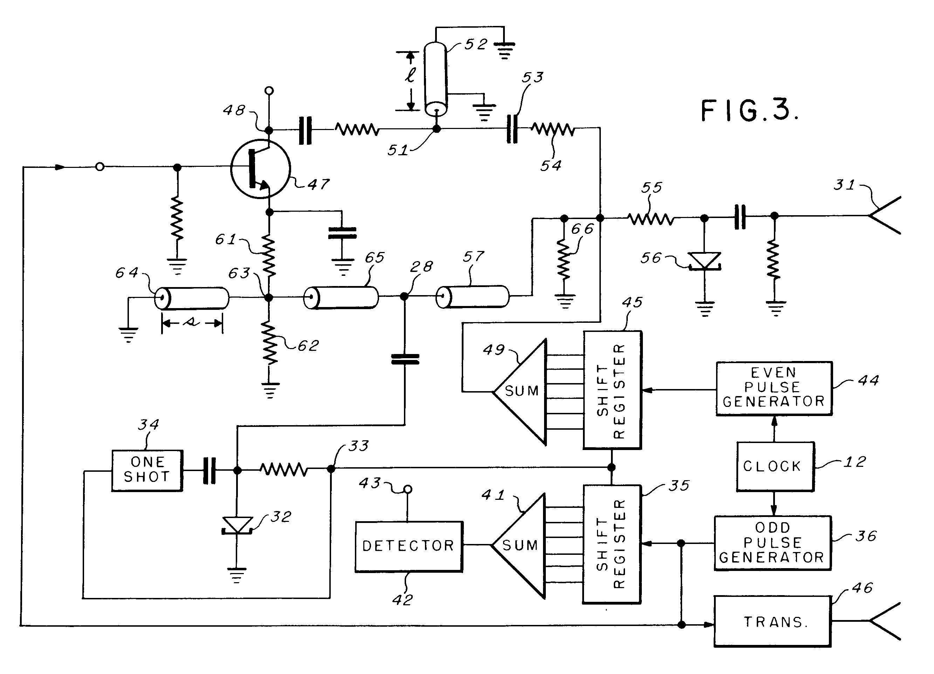

A second embodiment of the invention is shown schematically in Figure 3, wherein components similar to the components shown in Figure 1 bear similar reference numerals. A pulse from the odd pulse generator 36 triggers the transmitter 46 and causes the avalanche transistor 47, which may be a 2N2369A, to conduct heavily. This conduction causes the voltage at node 48 to decrease causing a negative-going voltage to couple to the input terminal 51 of a transmission line 52 which is short-circuited at a distance ℓ from the input terminal 51. The negative-going voltage that propagates along the transmission line 52 is reflected by the short-circuit termination and arrives at the input terminal 51 in phase opposition to the voltage thereat at a time substantially given by 2 ℓ/c, c being the propagation velocity along the transmission line 52. When the reflected pulse arrives at the input terminal 51, the voltage thereat is cancelled thereafter, thereby establishing a pulse at the input terminal 51 of duration 2 ℓ/c. This pulse is differentiated in the differentiating network including capacitor 53 and resistors 54, 55 to couple a negative impulse and, at a pulse interval thereafter, a positive impulse to a tunnel diode 56, which may be a GE262A. In the absence of a signal coupled from the antenna 31, the tunnel diode 56 is set in its low level state during the pulse length interval and couples a negative voltage to a node 28 via a delay line 57. When the transistor 47 conducts, the current therethrough is coupled through resistors 61, 62 to establish a positive-going voltage at the input terminal 63 of a transmission line 64 which is terminated with a short-circuit at a distance s from the input terminal 63. In a manner similar to that described with respect to the transmission line 52, a positive pulse of duration 2s/c is formed at the terminal 63 and coupled via a delay line 65 to node 28. The length of the transmission lines 52, 64 are substantially equal and the pulses formed thereby are of substantially equal duration. Resistors 61, 62 and the resistor 66 coupled between the input to the delay line 57 and ground, are selected to establish a voltage at node 28 consistent with the low level state of tunnel diode 32. When the antenna 31 does not receive a signal within the range gate interval, the signal at node 28 remains at the low level, the tunnel diode 32 does not change state and the tunnel diode 56 is reset to its high level state by the positive impulse due to the differentiation of the trailing edge of the negative-going pulse coupled from the pulse forming transmission line 52. If a signal is received by antenna 31, the tunnel diode 56 fires, coupling a high level signal to node 28 causing the tunnel diode 32 to change from its low level to its high level state thereby providing a pulse from node 33 to the shift register 35 for processing as previously described.

## Claims

1. Apparatus for detecting pulsed signals comprising:
- means (31) for receiving the pulsed signals;
- gating means (11, 14-16, 22,23) for providing gating signals;
- first bistable means (17) having a first insensitive and a second sensitive switchable stable states, said first bistable means (17) being responsive to the gating signals provided by the gating means for setting from the first state to the second state and for resetting from the second state to the first state, said first bistable means (17) being also responsive to the received pulsed signals when set to the second sensitive state so that it switches from this second state to the first state;
characterised in that it further comprises second bistable means (24) having a first insensitive and a second sensitive switchable stable states, said second bistable means (24) being responsive to the gating signals provided by the gating means for setting from the first state to the second state and for resetting from the second state to the first state, the second bistable means (24) being coupled to the first bistable means (17) with a node (28) therebetween,
the first and second bistable means being both in their first insensitive states except for a period of time during which the gating signals provided by the gating means set both first and second bistable means to their second sensitive states, so that the node (28) has substantially a low level signal thereat when the first and second bistable means are in the second insensitive state and a detectable level signal when a pulsed signal from the receiving means (31) causes the first bistable means to switch to the first insensitive stable state during said period of time during which the first and second bistable means are in their second sensitive states: and
third bistable means (32) having first and second switchable stable states coupled to the node (28) and responsive to the detectable level signal for switching from the first stable state to the second stable state, thereby generating an output pulsed signal.

2. Apparatus according to claim 1, characterised in that the gating means includes:
generator means (11) for providing first and second pulses of substantially equal duration and opposite polarity,
first means (15,16) coupled between the generator means and the first bistable means (17) for receiving and differentiating the first pulses; and
second means (22,23) coupled between the generator means and the second bistable means (24) for receiving and differentiating the second pulses.

3. Apparatus according to any of the preceding claims, characterised in that it includes:
first delay means (13) coupled between the first bistable means (17) and the node (28) for delaying signals for a first time duration; and
second delay means (14) coupled between the generator means (11) and the second differentiating means (22,23) for delaying signals and a second time duration, the first and second time durations being chosen such that signals from the first and second bistable means (17,24) substantially coalesce at the node (28).

4. Apparatus according to any of the preceding claims, characterised in that it further includes means (34) having an input terminal coupled to the third bistable means (32) and an output terminal coupled to the third bistable means for providing a signal at a predetermined time after a change of state of the third bistable means from the first state to the second state to reset the third bistable means to the first stable state.

5. Apparatus according to any of the preceding claims, characterised in that the first and second bistable means (17,24) are germanium tunnel diodes, and in that the third bistable means (32) is a gallium arsenide tunnel diode.

6. Apparatus for detecting pulsed signals comprising:
- means (31) for receiving the pulsed signals;
- gating means (11, 14-16, 22, 23) for providing gating signals.
- first bistable means (17) having a first insensitive and a second sensitive switchable stable states, said first bistable means (17) being responsive to the gating signals provided by the gating means for setting from the first state to the second state and for resetting from the second state to the first state, said first bistable means (17) being also responsive to the received pulsed signals when set to the second sensitive state so that it switches from this second state to the first state;
characterised by
- first delay means (65) coupled between a first node (28) and a second node (63) for delaying signals coupled thereto from the second node for a first time duration;
- second delay means (57) coupled between the first node (28) and a third node (51) for delaying signals coupled thereto from the third node for a second time duration;
- said gating means including signal means (47, 52, 61) coupled to the second and third nodes for generating switching signals at the second and third nodes that are substantially in phase opposition, the first and second delay means being chosen such that the switching signals from the gating means substantially coalesce at the first node;
- the first bistable means (56) being coupled to the third node (51) and being in its first insensitive state except for a period of time during which the gating signals provided by the gating means set the first bistable means to its second sensitive state, so that the node (28) has substantially a low level signal thereat when the first bistable means is in the second insensitive state and a detectable level signal when a pulsed signal from the receiving means (31) causes the first bistable means to switch to the first insensitive stable state during said period of time during which the first bistable means is in its second sensitive state; and
- second bistable means (32) having first and second switchable stable states coupled to the first node (28) and responsive to the detectable level signal for switching from the first stable state to the second stable state, thereby generating an output pulsed signal.

7. Apparatus according to claim 6, characterised in that signal means includes:
switch means (47) having a first terminal (48) coupled to the third node (51) and a second terminal coupled to the second node (63) and responsive to a signal coupled to an input terminal thereof for conducting current between first and second terminals for the duration of the coupled signal;
first pulse means (64) coupled to the second node (63) for providing a signal of predetermined polarity in response to current flow between the first and second terminals of the switch means;
second pulse means (52) coupled to the third node (51) for providing a signal of polarity opposite to said predetermined polarity in response to current flow between the first and second terminals of the switch means; and
means (53-55) coupled between the first bistable means (56) and the third node (51) for differentiating the signal of polarity opposite said predetermined polarity.

8. Apparatus according to claim 7, characterised in that the switch means is an avalanche transistor (47).

9. Apparatus according to any of claims 6 to 8, characterised in that the first bistable means (56) is a germanium tunnel diode and the second bistable means (32) is a gallium arsenide tunnel diode.

## Patentansprüche

1. Gerät zum Feststellen gepulster Signale mit:
- Mittel (31) zum Empfangen der gepulsten Signale;
- Torschalt- bzw. Auftastmittel (11, 14 - 16, 22, 23) zum Liefern von Torschalt- bzw. Auftastsignalen;
- erstem bistabilen Mittel (17) mit einem ersten unempfindlichen und einem zweiten empfindlichen, umschaltbaren stabilen Zustand, wobei das erste bistabile Mittel (17) auf die Auftastsignale anspricht, welche durch das Auftastmittel geliefert werden, um von dem ersten Zustand auf den zweiten Zustand umzustellen und um von dem zweiten Zustand auf den ersten Zustand zurückzustellen, wobei das erste bistabile Mittel (17) auch auf die empfangenen gepulsten Signale anspricht, wenn es auf den zweiten empfindlichen Zustand eingestellt ist, so daß es von diesem zweiten Zustand auf den ersten Zustand umschaltet;
dadurch gekennzeichnet, daß es weiter enthält ein zweites bistabiles Mittel (24) mit einem ersten unempfindlichen und einem zweiten empfindlichen, umschaltbaren stabilen Zustand, wobei das zweite bistabile Mittel (24) auf die Auftastsignale anspricht, welche durch das Auftastmittel geliefert werden, um von dem ersten Zustand auf den zweiten Zustand umzustellen und um von dem zweiten Zustand auf den ersten Zustand zurückzustellen, wobei das zweite bistabile Mittel (24) mit dem ersten bistabilen Mittel (17) mit einem Knoten (28) dazwischen gekoppelt ist,
das erste und zweite bistabile Mittel sich beide in ihren ersten unempfindlichen Zuständen abgesehen von einer Zeitspanne befinden, während welcher die Auftastsignale, die von dem Auftastmittel geliefert werden, sowohl das erste als auch zweite bistabile Mittel auf ihre zweiten empfindlichen Zustände einstellen, so daß der Knoten (28) im wesentlichen ein Kleinsignal bzw. Niedrigpegelsignal dort aufweist, wenn sich das erste und zweite bistabile Mittel in dem zweiten unempfindlichen Zustand befinden, und ein Signal mit feststellbarem Pegel, wenn ein gepulstes Signal von dem empfangenden Mittel (31) bewirkt, daß das erste bistabile Mittel auf den ersten, unempfindlichen stabilen Zustand während der Zeitspanne umschaltet, während der sich das erste und zweite bistabile Mittel in ihren zweiten empfindlichen Zuständen befinden; und
drittes bistabiles Mittel (32) mit ersten und zweiten, umschaltbaren stabilen Zuständen, welches mit dem Knoten (28) gekoppelt ist und auf das Signal mit feststellbarem Pegel zum Umschalten von dem ersten stabilen Zustand auf den zweiten stabilen Zustand anspricht, wobei dadurch ein gepulstes Ausgangssignal erzeugt wird.

2. Gerät nach Anspruch 1, dadurch gekennzeichnet, daß das Auftastmittel einschließt:
Generatormittel (11), um erste und zweite Pulse von im wesentlichen gleicher Dauer und entgegengesetzter Polarität zu liefern,
erstes Mittel (15, 16), welches zwischen das Generatormittel und das erste bistabile Mittel (17) gekoppelt ist, zum Empfangen und Differenzieren der ersten Pulse; und
zweites Mittel (22, 23), welches zwischen das Generatormittel und das zweite bistabile Mittel (24) gekoppelt ist, zum Empfangen und Differenzieren der zweiten Pulse.

3. Gerät nach irgendeinem der vorhergehenden Ansprüche, dadurch gekennzeichnet, daß es einschließt:
erstes Verzögerungsmittel (13), welches zwischen das erste bistabile Mittel (17) und den Knoten (28) gekoppelt ist, zum Verzögern von Signalen um eine erste Zeitspanne; und
zweites Verzögerungsmittel (14), welches zwischen das Generatormittel (11) und das zweite Differenziermittel (22, 23) gekoppelt ist, zum Verzögern von Signalen um eine zweite Zeitspanne, wobei die ersten und zweiten Zeitspannen derart gewählt werden, daß Signale von dem ersten und zweiten bistabilen Mittel (17, 24) bei den Knoten (28) im wesentlichen zusammenpassen.

4. Gerät nach irgendeinem der vorhergehenden Ansprüche, dadurch gekennzeichnet, daß es weiter einschließt Mittel (34) mit einem Eingangsanschluß, welcher mit dem dritten bistabilen Mittel (32) gekoppelt ist, und einem Ausgangsanschluß, welcher mit dem dritten bistabilen Mittel gekoppelt ist, zum Liefern eines Signals bei einer vorher bestimmten Zeit nach einer Änderung eines Zustandes des dritten bistabilen Mittels von dem ersten Zustand zu dem zweiten Zustand, um das dritte bistabile Mittel auf den ersten stabilen Zustand zurückzustellen.

5. Gerät nach irgendeinem der vorhergehenden Ansprüche, dadurch gekennzeichnet, daß das erste und zweite bistabile Mittel (17, 24) Germanium-Tunneldioden sind, und dadurch, daß das dritte bistabile Mittel (32) eine Galliumarsenid-Tunneldiode ist.

6. Gerät zum Feststellen gepulster Signale mit:
- Mittel (31) zum Emfangen der gepulsten Signale;
- Auftastmittel (11, 14 - 16, 22, 23) zum Liefern von Auftastsignalen;
- erstem bistabilen Mittel (17) mit einem ersten unempfindlichen und einem zweiten empfindlichen, umschaltbaren stabilen Zustand, wobei das erste bistabile Mittel (17) auf die Auftastsignale anspricht, welche durch das Auftastmittel geliefert werden, um von dem ersten Zustand auf den zweiten Zustand umzustellen und von dem zweiten Zustand auf den ersten Zustand zurückzustellen, wobei das erste bistabile Mittel (17) auch auf die empfangenen gepulsten Signale anspricht, wenn es auf den zweiten empfindlichen Zustand eingestellt ist, so daß es von diesem zweiten Zustand auf den ersten Zustand umschaltet;
gekennzeichnet durch
- erstes Verzögerungsmittel (65), welches zwischen einen ersten Knoten (28) und einen zweiten Knoten (63) gekoppelt ist, zum Verzögern von Signalen, welche damit von dem zweiten Knoten gekoppelt werden, um eine erste Zeitspanne;
- zweites Verzögerungsmittel (57), welches zwischen den ersten Knoten (28) und einen dritten Knoten (51) gekoppelt ist, zum Verzögern von Signalen, welche damit von dem dritten Knoten gekoppelt werden, um eine zweite Zeitspanne;
- das Auftastmittel, welches Signalmittel (47, 52, 61) einschließt, die mit den zweiten und dritten Knoten gekoppelt sind, zum Erzeugen von Umschaltsignalen bei den zweiten und dritten Knoten, die im wesentlichen in Gegenphase sind, wobei das erste und zweite Verzögerungsmittel derart gewählt werden, daß die Umschaltsignale von dem Auftastmittel bei dem ersten Knoten im wesentlichen zusammenpassen;
- das erste bistabile Mittel (56), welches mit dem dritten Knoten (51) gekoppelt ist und sich in seinem ersten unempfindlichen Zustand abgesehen von einer Zeitspanne befindet, während der die Auftastsignale, welche von dem Auftastmittel geliefert werden, das erste bistabile Mittel auf seinen zweiten empfindlichen Zustand einstellen, so daß der Knoten (28) im wesentlichen ein Niedrigpegelsignal dort aufweist, wenn das erste bistabile Mittel sich in dem zweiten unempfindlichen Zustand befindet, und ein Signal mit feststellbarem Pegel, wenn ein gepulstes Signal von dem empfangenden Mittel (31) bewirkt, daß das erste bistabile Mittel auf den ersten, unempfindlichen stabilen Zustand während der Zeitspanne umschaltet, während der das erste bistabile Mittel sich in seinem zweiten empfindlichen Zustand befindet; und
- zweites bistabiles Mittel (32) mit ersten und zweiten, umschaltbaren stabilen Zuständen, welches mit dem ersten Knoten (28) gekoppelt ist und auf das Signal mit feststellbarem Pegel zum Umschalten von dem ersten stabilen Zustand auf den zweiten stabilen Zustand anspricht, wobei dadurch ein gepulstes Ausgangssignal erzeugt wird.

7. Gerät nach Anspruch 6, dadurch gekennzeichnet, daß ein Signalmittel einschließt:
Umschaltmittel (47), welches einen ersten Anschluß (48), der mit dem dritten Knoten (51) gekoppelt ist, und einen zweiten Anschluß, der mit dem zweiten Knoten (63) gekoppelt ist, besitzt und auf ein Signal anspricht, das mit einem Eingangsanschluß davon gekoppelt wird, um einen Strom zwischen ersten und zweiten Anschlüssen für die Dauer des gekoppelten Signals zu leiten;
erstes Pulsmittel (64), welches mit dem zweiten Knoten (63) gekoppelt ist, um ein Signal einer vorher bestimmten Polarität als Antwort auf einen Stromfluß zwischen den ersten und zweiten Anschlüssen des Umschaltmittels zu liefern;
zweites Pulsmittel (52), welches mit dem dritten Knoten (51) gekoppelt ist, um ein Signal einer der vorher bestimmten Polarität entgegengesetzten Polarität als Antwort auf einen Stromfluß zwischen den ersten und zweiten Anschlüssen des Umschaltmittels zu liefern; und
Mittel (53 - 55), welches zwischen das erste bistabile Mittel (56) und den dritten Knoten (51) gekoppelt ist, zum Differenzieren des Signals einer der vorher bestimmten Polarität entgegengesetzten Polarität.

8. Gerät nach Anspruch 7, dadurch gekennzeichnet, daß das Umschaltmittel ein Lawinentransistor (47) ist.

9. Gerät nach irgendeinem der Ansprüche 6 bis 8, dadurch gekennzeichnet, daß das erste bistabile Mittel (56) eine Germanium-Tunneldiode ist und das zweite bistabile Mittel (32) eine Galliumarsenid-Tunneldiode ist.

## Revendications

1. Dispositif pour détecter des signaux pulsés, comprenant:
un moyen (31) pour recevoir les signaux pulsés;
un moyen de déclenchement (11,14-16,22,23) pour fournir des signaux de déclenchement;
un premier moyen bistable (17) ayant un premier état insensible et un second état sensible stables pouvant être commutés, ledit premier moyen bistable (17) réagissant aux signaux de déclenchement fournis par le moyen de déclenchement pour passer du premier état au second état et pour repasser du second état au premier état, ledit premier moyen bistable (17) réagissant aussi aux signaux pulsés reçus quand il est mis au second état sensible, de telle sorte qu'il commute de ce second état au premier état;
caractérisé en ce qu'il comprend en outre un deuxième moyen bistable (24) ayant un premier état insensible et un second état sensible stables pouvant être commutés, ledit deuxième moyen bistable (24) réagissant aux signaux de déclenchement fournis par le moyen de déclenchement pour passer du premier état au second état et pour repasser du second état au premier état, le deuxième moyen bistable (24) étant couplé au premier moyen bistable (17) par l'intermédiaire d'un noeud (28),
les premier et deuxième moyens bistables étant tous les deux à leurs premiers états insensibles excepté pendant une période de temps où les signaux de déclenchement fournis par le moyen de déclenchement mettent à la fois les premier et deuxième moyens bistables à leurs seconds états sensibles, de telle sorte que le noeud (28) comporte effectivement un signal de niveau bas quand les premier et deuxième moyens bistables sont au second état sensible et un signal de niveau détectable quand un signal pulsé provenant du moyen récepteur (31) fait passer le premier moyen bistable au premier état insensible stable pendant ladite période de temps où les premier et deuxième moyens bistables sont à leurs seconds états sensibles; et,
un troisième moyen bistable (32) ayant des premier et second états stables pouvant être commutés, couplé au noeud (28) et réagissant au signal de niveau détectable pour passer du premier état stable au second état stable, lui permettant d'engendrer un signal pulsé de sortie.

2. Dispositif selon la revendication 1, caractérisé en ce que le moyen de déclenchement inclut:
un moyen générateur (11) pour fournir des premières et secondes impulsions de durée sensiblement égale et de polarité opposée,
un premier moyen (15,16) couplé entre le moyen générateur et le premier moyen bistable (17) pour recevoir et différentier les premières impulsions; et,
un deuxième moyen (22,23) couplé entre le moyen générateur et le deuxième moyen bistable (24) pour recevoir et différentier les secondes impulsions.

3. Dispositif selon l'une quelconque des revendications 1 et 2, caractérisé en ce qu'il inclut:
un premier moyen à retard (13) couplé entre le premier moyen bistable (17) et le noeud (28) pour retarder les signaux pendant une première durée; et,
un deuxième moyen à retard (14) couplé entre le moyen générateur (11) et le deuxième moyen de différentiation (22,23) pour retarder les signaux pendant une deuxième durée, les première et deuxième durées étant choisies de telle sorte que les signaux provenant des premier et deuxième moyens bistables (17,24) se combinent effectivement au noeud (28).

4. Dispositif selon l'une quelconque des revendications 1 à 3, caractérisé en ce qu'il inclut en outre un moyen (34) ayant une borne d'entrée couplée au troisième moyen bistable (32) et une borne de sortie couplée au troisième moyen bistable pour fournir un signal à un temps prédéterminé après un changement d'état du troisième moyen bistable du premier état au second état pour remettre le troisième moyen bistable au premier état stable.

5. Dispositif selon l'une quelconque des revendications 1 à 4, caractérisé en ce que les premier et deuxième moyens bistables (17,24) sont des diodes tunnel au germanium, et en ce que le troisième moyen bistable (32) est une diode tunnel à l'arséniure de gallium.

6. Dispositif pour détecter des signaux pulsés, comprenant:
un moyen (31) pour recevoir les signaux pulsés;
un moyen de déclenchement (11,14-16,22,23) pour fournir des signaux de déclenchement;
un premier moyen bistable (17) ayant un premier état insensible et un second état sensible stables pouvant être commutés, ledit premier moyen bistable (17) réagissant aux signaux de déclenchement fournis par le moyen de déclenchement pour passer du premier état au second état et pour repasser du second état au premier état, ledit premier moyen bistable (17) réagissant aussi aux signaux pulsés reçus quand il est mis au second état sensible, de telle sorte qu'il commute de ce second état au premier état;
caractérisé par
un premier moyen à retard (65) couplé entre un premier noeud (28) et un deuxième noeud (63),pour retarder les signaux qui lui sont envoyés par le deuxième noeud pendant une première durée;
un deuxième moyen à retard (57) couplé entre le premier noeud (28) et un troisième noeud (51) pour retarder les signaux qui lui sont envoyés par le troisième noeud pendant une deuxième durée;
ledit moyen de déclenchement incluant un moyen à signaux (47,52,61) couplé aux deuxième et troisième noeuds pour engendrer des signaux de commutation aux deuxième et troisième noeuds qui sont effectivement en opposition de phase, les premier et deuxième moyens à retard étant choisis de telle sorte que les signaux de commutation provenant du moyen de déclenchement se combinent effectivement au premier noeud;
le premier moyen bistable (56) étant couplé au troisième noeud (51) et étant à son premier état insensible excepté pendant une période de temps où les signaux de déclenchement fournis par le moyen de déclenchement mettent le premier moyen bistable à son second état sensible, de telle sorte que le noeud (28) comporte effectivement un signal de niveau bas quand le premier moyen bistable est au second état insensible et un signal de niveau détectable quand un signal pulsé provenant du moyen récepteur (31) fait passer le premier moyen bistable au premier état insensible stable pendant ladite période de temps où le premier moyen bistable est à son second état sensible; et,
un deuxième moyen bistable (32) ayant des premier et second états stables pouvant être commutés, couplé au premier noeud (28) et réagissant au signal de niveau détectable pour passer du premier état stable au second état stable, lui permettant d'engendrer un signal pulsé de sortie.

7. Dispositif selon la revendication 6, caractérisé en ce que le moyen à signaux inclut:
un moyen commutateur (47) ayant une première borne (48) couplée au troisième noeud (51) et une seconde borne couplée au deuxième noeud (63) et réagissant à un signal envoyé à une de ses bornes d'entrée pour laisser passer un courant entre la première et la seconde borne pendant la durée du signal envoyé;
un premier moyen à impulsions (64) couplé au deuxième noeud (63) pour fournir un signal de polarité prédéterminée en réponse à un passage de courant entre la première et la seconde borne du moyen commutateur;
un deuxième moyen à impulsions (52) couplé au troisième noeud (51) pour fournir un signal de polarité opposée à ladite polarité prédéterminée en réponse au passage du courant entre la première et la seconde borne du moyen commutateur; et,
un moyen (53-55) couplé entre le premier moyen bistable (56) et le troisième noeud (51) pour différentier le signal de polarité opposée à ladite polarité prédéterminée.

8. Dispositif selon la revendication 7, caractérisé en ce que le moyen commutateur est un transistor à avalanche (47).

9. Dispositif selon l'une quelconque des revendications 6 à 8, caractérisé en ce que le premier moyen bistable (56) est une diode tunnel au germanium et le deuxième moyen bistable (32) est une diode tunnel à l'arséniure de gallium.
